# EUROPEAN PATENT SPECIFICATION

(11) **EP 4 158 423 B1**
(45) Date of publication and mention of the grant of the patent: **27.05.2026**
(21) Application number: 21720459.3
(22) Date of filing: 21.04.2021
(51) Int. Cl.: G03F 1/62, G02B 5/20, G03F 7/20, G21K 1/06, G02B 5/08, G02B 5/09, G21K 1/10, H01J 5/18

(54) **OPTICAL ELEMENT AND PELLICLE MEMBRANE FOR A LITHOGRAPHIC APPARATUS**
OPTISCHES ELEMENT UND MEMBRAN FÜR EINEN LITHOGRAPHISCHEN APPARAT
ÉLÉMENT OPTIQUE ET MEMBRANE DE PELLICULE POUR APPAREIL LITHOGRAPHIQUE

(30) Priority: 26.05.2020 EP 20176421
(43) Date of publication of application: 05.04.2023
(73) Proprietor: ASML Netherlands B.V., 5500 AH Veldhoven (NL)
(72) Inventor: HOUWELING, Zomer, Silvester, 5500 AH Veldhoven (NL); HILDENBRAND, Volker, Dirk, 5500 AH Veldhoven (NL); KLEIN, Alexander, Ludwig, 5500 AH Veldhoven (NL); VERMEULEN, Paul, Alexander, 5500 AH Veldhoven (NL)
(74) Representative: ASML Netherlands B.V.
(86) International application number: PCT/EP2021/060294
(87) International publication number: WO 2021/239337

(56) References cited:
- WO-A1-2019/091932
- US-A1- 2012 141 923
- US-A1- 2019 129 299
- BRADOW R ET AL: "Ruthenium Perovskite Catalysts for Lean NO* Automotive Emission Control", IND. ENG. CHEM. RES, vol. 34, 1 January 1995 (1995-01-01), pages 1929 - 1932, XP055780694, Retrieved from the Internet <URL:https://pubs.acs.org/doi/pdf/10.1021/ie00045a001>
- JIN-WU JIANG ET AL: "Thermal expansion in carbon nanotubes and graphene: nonequilibrium Green's function approach", ARXIV.ORG, CORNELL UNIVERSITY LIBRARY, 201 OLIN LIBRARY CORNELL UNIVERSITY ITHACA, NY 14853, 10 September 2009 (2009-09-10), XP080365971, DOI: 10.1103/PHYSREVB.80.205429

## Description

### TECHNICAL FIELD

The present invention relates to an optical element for a lithographic apparatus. The present invention also relates to methods of manufacturing optical elements and pellicle membranes, as well as pellicle membranes for lithographic apparatuses and methods.

### BACKGROUND

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g. a mask) onto a layer of radiation-sensitive material (resist) provided on a substrate.

The wavelength of radiation used by a lithographic apparatus to project a pattern onto a substrate determines the minimum size of features which can be formed on that substrate. A lithographic apparatus which uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

A lithographic apparatus includes a patterning device (e.g. a mask or reticle). Radiation is provided through or reflected off the patterning device to form an image on a substrate. A membrane assembly, also referred to as a pellicle, may be provided to protect the patterning device from airborne particles and other forms of contamination. Contamination on the surface of the patterning device can cause manufacturing defects on the substrate.

Pellicles may also be provided for protecting optical components other than patterning devices. Pellicles may also be used to provide a passage for lithographic radiation between regions of the lithography apparatus which are sealed from one another. Pellicles may also be used as filters, such as spectral purity filters or as part of a dynamic gas lock of a lithographic apparatus.

A mask assembly may include the pellicle which protects a patterning device (e.g. a mask) from particle contamination. The pellicle may be supported by a pellicle frame, forming a pellicle assembly. The pellicle may be attached to the frame, for example, by gluing or otherwise attaching a pellicle border region to the frame. The frame may be permanently or releasably attached to a patterning device.

Due to the presence of the pellicle in the optical path of the EUV radiation beam, it is necessary for the pellicle to have high EUV transmissivity. A high EUV transmissivity allows a greater proportion of the incident radiation through the pellicle. In addition, reducing the amount of EUV radiation absorbed by the pellicle may decrease the operating temperature of the pellicle. Since transmissivity is at least partially dependent on the thickness of the pellicle, it is desirable to provide a pellicle which is as thin as possible whilst remaining reliably strong enough to withstand the sometimes hostile environment within a lithography apparatus.

It is therefore desirable to provide a pellicle which is able to withstand the harsh environment of a lithographic apparatus, in particular an EUV lithography apparatus. It is particularly desirable to provide a pellicle which is able to withstand higher powers than previously.

Whilst the present application generally refers to pellicles in the context of lithography apparatus, in particular EUV lithography apparatus, the invention is not limited to only pellicles and lithography apparatus and it is appreciated that the subject matter of the present invention may be used in any other suitable apparatus or circumstances as defined by the claims.

For example, the methods of the present invention may equally be applied to spectral purity filters. Some EUV sources, such as those which generate EUV radiation using a plasma, do not only emit desired 'in-band' EUV radiation, but also undesirable (out-of-band) radiation. This out-of-band radiation is most notably in the deep UV (DUV) radiation range (100 to 400 nm). Moreover, in the case of some EUV sources, for example laser produced plasma EUV sources, the radiation from the laser, usually at 10.6 micrometer, presents a significant out-of-band radiation.

In a lithographic apparatus, spectral purity is desired for several reasons. One reason is that the resist is sensitive to out of-band wavelengths of radiation, and thus the image quality of patterns applied to the resist may be deteriorated if the resist is exposed to such out-of-band radiation. Furthermore, out-of-band radiation infrared radiation, for example the 10.6 micrometer radiation in some laser produced plasma sources, leads to unwanted and unnecessary heating of the patterning device, substrate, and optics within the lithographic apparatus. Such heating may lead to damage of these elements, degradation in their lifetime, and/or defects or distortions in patterns projected onto and applied to a resist-coated substrate.

A typical spectral purity filter may be formed, for example, from a silicon foundation structure (e.g. a silicon grid, or other member, provided with apertures) that is coated with a reflective metal, such as molybdenum. In use, a typical spectral purity filter might be subjected to a high heat load from, for example, incident infrared and EUV radiation. The heat load might result in the temperature of the spectral purity filter being above 800°C. Under the high head load, the coating can delaminate due to a difference in the coefficients of linear expansion between the reflective molybdenum coating and the underlying silicon support structure. Delamination and degradation of the silicon foundation structure is accelerated by the presence of hydrogen, which is often used as a gas in the environment in which the spectral purity filter is used in order to suppress debris (e.g. debris, such as particles or the like), from entering or leaving certain parts of the lithographic apparatus. Thus, the spectral purity filter may be used as a pellicle, and vice versa. Therefore, reference in the present application to a 'pellicle' is also reference to a 'spectral purity filter'. Although reference is primarily made to pellicles in the present application, all of the features could equally be applied to spectral purity filters.

The present invention additionally or alternatively is directed to optical elements, such as mirrors, of lithographic apparatuses are exposed to a plasma environment.

The present invention has been devised in an attempt to address at least some of the problems identified above.

Relevant background art is disclosed in US 2012/0141923 A1 showing a protective capping on a mask assembly and US 2019/0129299 A1 showing a non-volatile material for protecting a pellicle.

### SUMMARY OF THE INVENTION

A first aspect of the present invention is defined by independent claim 1.

Existing optical elements use a thin layer of ruthenium metal to prevent chemical degradation under the influence of EUV radiation and plasma. Ruthenium is somewhat chemically inert and forms a thin native oxide layer which is readily reduced upon exposure to EUV excited hydrogen plasma. A zirconium oxide layer may also be included to prevent blistering of the ruthenium layer in use.

One disadvantage of the use of ruthenium is its tendency to catalytically decompose volatile hydrogen compounds of materials such as silicon and phosphorus. The decomposition of such compounds deposits such materials on the ruthenium surface. This reduces the reflectivity of mirrors or reduces the transmissivity of pellicles, meaning that either the source power needs to be increased to maintain the same scanner throughput or the throughput of the scanner decreases over time. It is desirable to address this disadvantage. Although a zirconium dioxide layer can be added, which does not form volatile hydrogen compounds, zirconium dioxide is not produced under the conditions seen in an operating lithographic apparatus and can change morphology over time. As such, the protective effect of zirconium dioxide decreases over time. Furthermore, ruthenium cannot protect underlying layers from oxidation under all conditions.

It has been surprisingly found that it is possible to provide an anchor layer in an optical element which supports a top-layer having self-terminating growth in use in an operating lithographic apparatus. These self-terminating top layers are surprisingly resistant to etching by hydrogen ions and radicals and are also resistant to deposition of unwanted additional materials, such as silicon, during exposure in lithographic apparatuses. It has been found that the self-terminating top layer does not grow in thickness beyond a given point as a result of further material being deposited thereon, nor does it shrink in thickness as a result of etching by a plasma. As such, this form of coating is very important for lithographic apparatuses and methods as the performance of the optical elements will not change over time and it is stable under operating conditions. Experiments have shown that such self-limiting growth layers are very difficult if not impossible for such layers to be removed by plasma etching.

The optical element may further comprise a substrate layer. The substrate layer may comprise one of more of silicon, carbon, quartz, and sapphire. Silicon is commonly used as a substrate in optical elements, especially for optical elements used in lithography, since it has high EUV transmissivity and is able to withstand the conditions within an operating lithographic apparatus. Carbon, preferably in the form of nanotubes, which may be single-, double- or multi-walled, may also be used as a substrate given its ability to withstand very high temperatures, Quartz and sapphire are materials which are commonly used in mirrors and viewing windows of lithographic apparatuses as well as other apparatuses in which plasma is generated. Sapphire windows are generally very etch resistant but in some cases quartz is preferred for which etching of the quartz can present a problem. In either case, deposition of contaminants, such as silicon, can be a problem. The substrate may be a mirror multilayer stack.

The optical element may also comprise a wetting layer. The wetting layer may comprise one or more elements selected from the group consisting of chromium, titanium, and molybdenum. The wetting layer may comprise a nitride of one or more of these metals. The wetting layer is preferably disposed between a substrate later and the anchor layer. The wetting layer prevents or reduces thermal dewetting of the metallic anchoring layer which is deposited over the wetting layer. Suitable wetting layers have high oxygen affinity, which results in passivation of silicon oxide layers which are often used as a substrate. In addition, the wetting layer sticks well to the deposited overlayers, which results in attenuation of surface migration. Wetting materials have atoms which have a large atomic radius which results in attenuation of atomic migration into the substrate materials.

The wetting layer thickness may be selected depending on the application to which the optical element is to be applied. For pellicles, the thickness of the wetting layer is desired to be as thins as possible whilst still performing its function. Preferably, the thickness of the wetting layer is 5 nm or less. The thickness of the wetting layer may be 2 nm or less. The thickness of the wetting layer may be 1 nm or less. The thickness of the wetting layer may be 0.5 nm or less.

The optical element includes the top layer. The top layer comprises one or more elements selected from the group consisting of Si, Ge, Sn, B, P, Mg, and Al. The top layer may comprise an oxide of one or more of such elements.

The anchor layer and the top layer form a plasma etch barrier. It has been found that plasma etch barriers which have self-terminating growth are particularly resistant to erosion or attack by plasma.

The anchor layer comprises one or more elements selected from the list consisting of platinum, ruthenium, osmium, rhodium, iridium, and palladium. The anchor layer functions as an adhesor to the self-limiting top layer. It has been found that not all elements can serve as a suitable anchor layer as they do not result in a top layer having self-limiting growth and high stability in a plasma environment.

The optical element is a pellicle assembly or a mirror. The pellicle assembly is a pellicle assembly for a lithographic apparatus, such as an EUV lithography apparatus or a lithography apparatus using light of a wavelength longer or shorter than EUV. Similarly, the mirror is a mirror for use in a lithography apparatus, such as a field facet mirror.

A second aspect of the present invention is defined by claim 9.

It will be appreciated that the features of the first aspect of the present invention may be combined with those of the second aspect, and *vice versa.*

The method according to the second aspect of the present invention allows for the manufacture of optical elements which display self-limiting growth when used in an operating lithographic apparatus.

The top layer comprises one or more elements selected from the group consisting of silicon, germanium, tin, lead, boron, phosphorus, magnesium, and aluminium.

The wetting layer may comprise one or more elements selected from the group consisting of chromium, titanium and molybdenum. The wetting layer may comprise a nitride of such elements.

The anchor layer comprises one or more elements selected from the group consisting of Pt, Ru, Os, Rh, Ir, and Pd.

The optical element may comprise any of the substrates mentioned in respect of the first aspect of the present invention.

The optical element may include an anchor layer-top layer combination selected from the list consisting of: [Ru-SiOₓ], [Pt-SiOₓ], [Rh-SiOₓ], [Ru-GeOₓ], [Rh-GeOₓ], [Ru-SnOₓ], and [Rh-SnOₓ]. These combinations of anchor layer and top layer display resistance to etching by hydrogen plasma as well as self-limiting growth within a lithography apparatus.

The optical element according to any preceding claim, wherein the optical element includes a carbon nanotube substrate, a molybdenum wetting layer, a ruthenium anchor layer, and a silicon oxide top layer. The carbon nanotube may be a single walled carbon nanotube. This combination of layers also displays advantageous resistance to etching by hydrogen plasma as well as self-limiting growth of the top layer during use in a lithographic apparatus.

According to a third aspect of the present invention, there is provided an optical element manufactured according to the method of the second aspect of the present invention. The optical element is suitable for use in a lithographic apparatus, such as an EUV lithographic apparatus. The optical element is a pellicle or a mirror.

A fourth aspect of the present invention is defined by claim 10.

It will be appreciated that the pellicle membranes described in respect of the fourth aspect of the present invention may be included in the optical element of the first or third aspects of the present invention, or manufactured at least partially by the method according to the second aspect of the present invention.

It will be appreciated that certain layers or portions of a pellicle membrane may be damaged during use in a lithographic apparatus. For example, pellicle membranes comprising silicon and silicon compounds display hydrogen induced outgassing. Hydrogen is is able to remove the native oxide layer and then react with the silicon core to release gaseous silane. Similarly, carbon-based pellicles may be eroded by exposure to hydrogen plasma. It is desirable to prevent etching of the pellicle membrane as this may lead to a weakening of the membrane and possibly failure. It is desirable to extend the lifespan of a pellicle membrane to ensure the maximum amount of uptime of a lithographic apparatus. According to the fourth aspect of the present invention, a non-volatile sacrificial material is provided as part of the pellicle membrane which protects other parts of the pellicle membrane from erosion. As such, these materials are sacrificed in order to prevent or reduce the degradation of the other materials. By non-volatile, it is meant that these materials are not gaseous in their oxidised, native or reduced form. For example, silane is gaseous at ambient temperatures and pressures as so is considered as being volatile. In contrast, metallic silver and silver oxide are both solids at ambient temperatures. By sacrificial, it is understood that this means that this material is preferentially attacked by the plasma and is therefore sacrificed in order to protect the rest of the pellicle membrane.

The optical element according to the fourth aspect of the present invention may include any of the features described in respect of the first aspect of the present invention.

The non-volatile sacrificial material may comprise a material having a higher redox potential than at least one other material in the membrane. As such, the non-volatile sacrificial material may have a higher redox potential than the material which is to be protected.

Redox potentials may be positive or negative. In the present application, a higher redox potential means one which is more positive. For example, a redox potential of -0.1 V is higher than a redox potential of -0.8 V, and a positive redox potential is higher than a negative redox potential, irrespective of the absolute magnitude of the potential.

Within the environment of a lithographic apparatus, there is a highly reducing atmosphere and so materials such as carbon and silicon can be readily reduced to silane and hydrocarbons respectively. By providing a sacrificial material which has a more positive reaction potential, the sacrificial material is preferentially reduced and so the other materials, such as silicon or carbon are protected. As such, it is preferred that the sacrificial material has a higher (more positive) redox potential than silicon or carbon, which has respective redox potentials of -0.14 V and +0.13 V in respect of the reduction from elemental silicon or carbon to silane or methane. It is preferable that the oxidised and reduced form of the sacrificial material are non-volatile so that they are not released into the atmosphere of the lithographic apparatus since they could then reach another part of the apparatus and cause damage or a loss in performance.

Examples of redox reactions which occur in an operating lithography apparatus include:

*SiO*₂ *+* 4*H⁺ + 4e⁻⇄ Si(s) + 2H₂O*

*Si +* 4*H⁺ +* 4*e⁻⇄ SiH*₄(*g*)

*C +* 4*H⁺ +* 4*e⁻⇄CH*₄(*g*)

*RuO*₂ *+* 4*H⁺ +* 4*e⁻⇄Ru*(*s*) *+ 2H₂O*

The reaction potential for the reduction of silicon oxide is -0.91 V. The reaction potential for the reduction of silicon is -0.14 V. The reaction potential for the reduction of carbon is +0.13 V. The reaction potential for the reduction of ruthenium oxide is +0.68 V. As such, in a system comprises these elements/compounds, it would be the ruthenium oxide which is reduced first as it has the most positive reduction potential and therefore a greater affinity for electrons and a tendency to be reduced.

The non-volatile sacrificial material may have a redox potential which is at least 0.35 V higher than another material of the pellicle membrane. In particular, the redox potential may be at least 0.35 V higher than a material which is desired to be protected in the pellicle membrane, such as silicon or carbon.

The non-volatile sacrificial material and/or its reaction product with hydrogen is preferably stable in air. That is, the sacrificial material does not rapidly (within a few minutes or seconds) react in air under ambient conditions, with the exception of the creation of a thin native oxide layer. The non-volatile sacrificial material and/or its reaction product with hydrogen is preferably stable within the atmosphere of an operating lithographic apparatus. For example, where the sacrificial material is a metal oxide, the metal oxide and the metallic product of its reduction with hydrogen are non-volatile.

The non-volatile sacrificial material may comprise one or more of the elements selected from the list consisting of silver, gold, platinum, iron, manganese, and tellurium. The material may comprise an oxidised form of such elements, such as an oxide. The oxides of these materials have more positive redox potentials that silicon and carbon and so are reduced first, thereby protecting the silicon and carbon.

The non-volatile sacrificial material may comprise an oxide which may be reduced by a hydrogen plasma to the metallic element. By reacting with hydrogen more readily that other materials of the pellicle membrane, these materials are preferentially reduced and so the other materials are not eroded or are at least eroded at a much lower rate than would otherwise be the case. This in turn extends the operating life of the pellicle membrane.

The membrane may be configured to have the non-volatile sacrificial material in direct contact with the plasma environment of a lithographic apparatus. As such, the non-volatile sacrificial material may be on the surface of the pellicle membrane. As such, the sacrificial material is able to react with the hydrogen plasma in order to protect the rest of the pellicle membrane.

The non-volatile sacrificial material is in the form of a discontinuous layer. The non-volatile sacrificial layer is in the form of a discrete islands and/or grains. It is not necessary for the sacrificial material to be provided across the entire extent of the pellicle membrane as it is able to protect an area of the pellicle membrane larger than the area covered by the sacrificial material. In addition, since it is desirable to have high transmissivity of the pellicle membrane, it may be undesirable to include an additional material layer when it is not necessary. The use of a discontinuous layer or islands/grains allows the membrane to retain high transmissivity whilst also benefiting from the protective effect of the non-volatile sacrificial material.

The non-volatile sacrificial material is provided in an area of the membrane outside the main light path of an operating lithographic apparatus. It will be appreciated that a pellicle membrane is in the path of the light used in the lithographic apparatus. The light is not evenly distributed across the entire surface of the pellicle membrane. Instead there is an area which is subjected to the highest intensity of light. Since it is desirable for the maximum amount of light to be allowed through the pellicle membrane, it is also desirable that there is maximum transmissivity in the areas of maximum light intensity. Therefore, the non-volatile sacrificial material is preferably positioned away from the area of maximum light intensity. In this way, the beneficial effects of the sacrificial material are realised and the decrease in transmissivity is managed.

The non-volatile sacrificial material may be provided in a border region of the pellicle membrane. Since the maximum intensity of light passes through the central region of the pellicle membrane, positioning the sacrificial material in an area surrounding the central region limits the decrease in transmissivity caused by the addition of the sacrificial material.

The pellicle membrane according to the fourth aspect of the present invention may form part of the optical element of the first aspect of the present invention.

According to a fifth aspect, there is provided a pellicle assembly including the pellicle membrane according to the fourth aspect of the present invention.

According to a sixth aspect, there is provided the use of an optical element or pellicle membrane according to any aspect of the present invention in a lithographic apparatus or method.

According to a seventh aspect, there is provided a lithographic apparatus comprising an optical element or pellicle membrane according to any aspect of the present invention.

It will be appreciated that features described in respect of one embodiment may be combined with any features described in respect of another embodiment and all such combinations are expressly considered and disclosed herein.

### BRIEF DESCRIPTION OF THE DRAWINGS

Embodiments of the invention will now be described, by way of example only, with reference to the accompanying schematic drawing in which corresponding reference symbols indicate corresponding parts, and in which:
Figure 1 depicts a lithographic apparatus according to an embodiment of the invention;
Figure 2 is a schematic depiction of an optical element according to an embodiment of the present invention; and
Figure 3 is a schematic depiction of a portion of an optical element according to an embodiment of the present invention.

The features and advantages of the present invention will become more apparent from the detailed description set forth below when taken in conjunction with the drawings, in which like reference characters identify corresponding elements throughout. In the drawings, like reference numbers generally indicate identical, functionally similar, and/or structurally similar elements.

### DETAILED DESCRIPTION

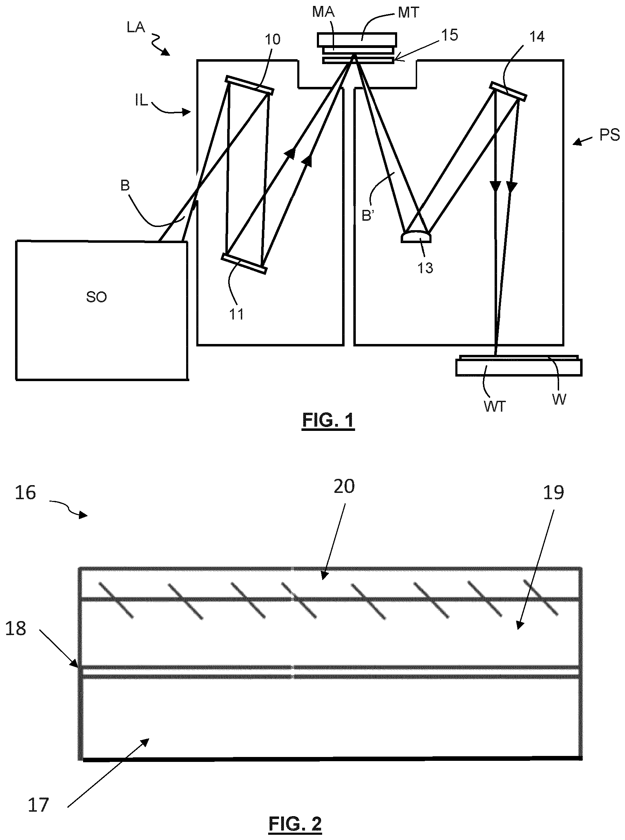

Figure 1 shows a lithographic system including a pellicle 15 (also referred to as a membrane assembly) according to the present invention. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask), a projection system PS and a substrate table WT configured to support a substrate W. The illumination system IL is configured to condition the radiation beam B before it is incident upon the patterning device MA. The projection system is configured to project the radiation beam B (now patterned by the mask MA) onto the substrate W. The substrate W may include previously formed patterns. Where this is the case, the lithographic apparatus aligns the patterned radiation beam B with a pattern previously formed on the substrate W. In this embodiment, the pellicle 15 is depicted in the path of the radiation and protecting the patterning device MA. It will be appreciated that the pellicle 15 may be located in any required position and may be used to protect any of the mirrors in the lithographic apparatus.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Figure 1 is of a type which may be referred to as a laser produced plasma (LPP) source. A laser, which may for example be a CO₂ laser, is arranged to deposit energy via a laser beam into a fuel, such as tin (Sn) which is provided from a fuel emitter. Although tin is referred to in the following description, any suitable fuel may be used. The fuel may for example be in liquid form, and may for example be a metal or alloy. The fuel emitter may comprise a nozzle configured to direct tin, e.g. in the form of droplets, along a trajectory towards a plasma formation region. The laser beam is incident upon the tin at the plasma formation region. The deposition of laser energy into the tin creates a plasma at the plasma formation region. Radiation, including EUV radiation, is emitted from the plasma during de-excitation and recombination of ions of the plasma.

The EUV radiation is collected and focused by a near normal incidence radiation collector (sometimes referred to more generally as a normal incidence radiation collector). The collector may have a multilayer structure which is arranged to reflect EUV radiation (e.g. EUV radiation having a desired wavelength such as 13.5 nm). The collector may have an elliptical configuration, having two ellipse focal points. A first focal point may be at the plasma formation region, and a second focal point may be at an intermediate focus, as discussed below.

The laser may be separated from the radiation source SO. Where this is the case, the laser beam may be passed from the laser to the radiation source SO with the aid of a beam delivery system (not shown) comprising, for example, suitable directing mirrors and/or a beam expander, and/or other optics. The laser and the radiation source SO may together be considered to be a radiation system.

Radiation that is reflected by the collector forms a radiation beam B. The radiation beam B is focused at a point to form an image of the plasma formation region, which acts as a virtual radiation source for the illumination system IL. The point at which the radiation beam B is focused may be referred to as the intermediate focus. The radiation source SO is arranged such that the intermediate focus is located at or near to an opening in an enclosing structure of the radiation source.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system comprises a plurality of mirrors 13, 14 which are configured to project the radiation beam B onto a substrate W held by the substrate table WT. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 1, the projection system may include any number of mirrors (e.g. six mirrors).

The radiation sources SO shown in Figure 1 may include components which are not illustrated. For example, a spectral filter may be provided in the radiation source. The spectral filter may be substantially transmissive for EUV radiation but substantially blocking for other wavelengths of radiation such as infrared radiation.

In an embodiment the membrane assembly 15 is a pellicle for the patterning device MA for EUV lithography. The membrane assembly 15 of the present invention can be used for a dynamic gas lock or for a pellicle or for another purpose. In an embodiment the membrane assembly 15 comprises a membrane formed from the at least one membrane layer configured to transmit at least 90% of incident EUV radiation. In order to ensure maximized EUV transmission and minimized impact on imaging performance it is preferred that the membrane is only supported at the border.

If the patterning device MA is left unprotected, the contamination can require the patterning device MA to be cleaned or discarded. Cleaning the patterning device MA interrupts valuable manufacturing time and discarding the patterning device MA is costly. Replacing the patterning device MA also interrupts valuable manufacturing time.

Figure 2 depicts an embodiment of a pellicle membrane according to the present invention. The pellicle assembly 15 includes a pellicle membrane generally depicted as 16. The pellicle membrane 16 include a substrate 17. The substrate 17 is generally thicker than the other layers which make up the pellicle membrane 16. The depiction of Figure 2 is exemplary and is not indicative of the true relative thicknesses of the various layers. The substrate 17 is generally silicon or carbon, which may be in the form of carbon nanotubes. A wetting layer 18 is disposed on the substrate 17. The wetting layer 17 serves to reduce or eliminate dewetting of the overlying anchor layer 19. A self-limiting top layer 20 is disposed on anchor layer 19. The hashed lines between anchor layer 19 and self-limiting top layer 20 depict the strong bond between the two layers which serves to prevent etching of the self-limiting top layer 20.

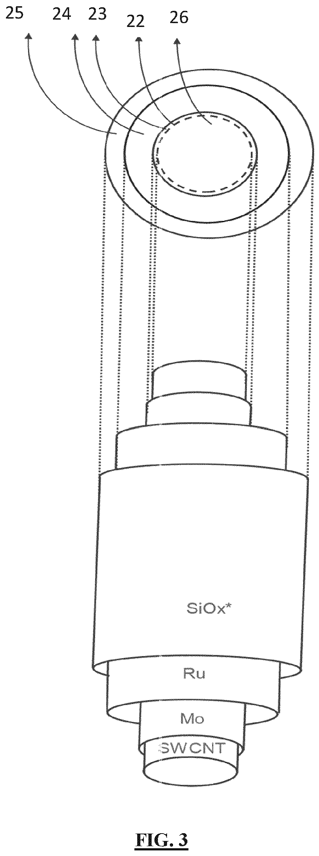

Figure 3 depicts an embodiment of a pellicle membrane according to the present invention. In particular, Figure 3 depicts a portion of a pellicle membrane comprising a carbon nanotube (CNT) substrate 22. The carbon nanotube 22 has a hollow core 26. The depicted embodiment is a single wall carbon nanotube, although it will be appreciated that double- and multi-walled carbon nanotubes are also possible substrates. In the depicted embodiment, the CNT has a diameter of around 10 nm, although the invention is not particularly limited to this diameter and other diameters may be used. Disposed on the CNT substrate 22, there is a wetting layer 23 of molybdenum. The thickness of the molybdenum layer is from around 0.1 nm to around 1 nm in thickness. The molybdenum layer functions as a wetting layer to prevent or substantially reduces the tendency of the overlying anchor layer 24 to dewet. In the depicted embodiment, the anchor layer 24 comprises ruthenium. The thickness of the ruthenium layer is from around 2 nm to around 4 nm. A self-terminating non-etchable top layer 25 is provided on the anchor layer 24. In the depicted embodiment, the self-terminating non-etchable top layer 25 comprises silicon oxide. The thickness of the silicon oxide layer is from around 1 nm to around 2.5 nm in thickness. A pellicle membrane having such a configuration displays almost complete resistance to etching in a lithographic apparatus and also has EUV transmissivity of over 90% as well as a thermal emissivity of over 50%. As such, a pellicle apparatus comprising such a membrane has advantageous mechanical lifetime in a lithography apparatus, particularly an EUV lithography apparatus, as well as improved etch resistance to plasmas.

### EXAMPLES

The following examples provide specific embodiments of the present invention. These examples are not intended to be limiting to the scope of the invention.

The following table includes combinations of anchor layer and self-limiting top layer which are particularly suitable in resisting etching in a lithographic apparatus.

| **Anchor Layer** | **Self-limiting top layer (and oxides thereof)** |
|---|---|
| Ruthenium | Si, Ge, Sn, B, P, Mg, or Al |
| Platinum | Si, Ge, Sn, B, P, Mg, or Al |
| Rhodium | Si, Ge, Sn, B, P, Mg, or Al |
| Osmium | Si, Ge, Sn, B, P, Mg, or Al |
| Iridium | Si, Ge, Sn, B, P, Mg, or Al |
| Palladium | Si, Ge, Sn, B, P, Mg, or Al |

It has been found that combinations of ruthenium anchor layers with silicon oxide top layers, and platinum anchor layers with silicon oxide top layers are particularly stable to etching in a lithographic apparatus.

On the other hand, it has been found that a copper of aluminium anchor layer does not offer the same self-limiting growth top layer with resistance to etching.

While specific embodiments of the invention have been described above, it will be appreciated that the invention is practiced as defined by the claims.

## Claims

1. An optical element for a lithographic apparatus (LA), wherein the optical element is a pellicle assembly (15) or a mirror (10, 11, 13, 14), and wherein the optical element comprises:
- a top layer (20, 25) having self-terminating growth in an operating lithographic apparatus or plasma containing environment, wherein the top layer comprises one or more elements selected from the group consisting of Si, Ge, Sn, B, P, Mg, and Al; and
- an anchor layer (19, 24) selected to support the top layer, wherein the anchor layer comprises one or more elements selected from the group consisting of Pt, Ru, Os, Rh, Ir, and Pd; and
wherein the anchor layer and the top layer form a plasma etch barrier.

2. The optical element according to claim 1, wherein the top layer comprises an oxide of one or more of such elements.

3. The optical element according to any preceding claim, wherein the optical element includes an anchor layer-top layer combination selected from the list consisting of: Ru-SiOx, Pt-SiOx, Rh-SiOx, Ru-GeOx, Rh-GeOx, Ru-SnOx, and Rh-SnOx.

4. The optical element according to any preceding claim, said optical element further comprising a wetting layer (18, 23).

5. The optical element according to claim 4, wherein the wetting layer comprises one or more elements selected from the group consisting of Cr, Ti, and Mo, optionally wherein the wetting layer comprises TiN.

6. The optical element according to any preceding claim, said optical element further comprising a substrate layer (17, 22).

7. The optical element according to claim 6, wherein the substrate comprises carbon nanotubes.

8. The optical element according to claim 7 in combination with any of claims 4-5, comprising a said wetting layer of molybdenum, a said anchor layer of ruthenium, and a said top layer of silicon oxide.

9. A method of manufacturing an optical element according to any preceding claim, said method comprising the steps of: depositing the top layer on the anchor layer via exposure to plasma, preferably electromagnetically induced plasma.

10. A pellicle membrane (16) for a lithographic apparatus, said pellicle membrane including a non-volatile sacrificial material protecting other parts of the pellicle membrane from erosion when exposed to hydrogen plasma, **characterized in that** the non-volatile sacrificial material being in the form of discrete islands and/or grains.

11. The pellicle membrane according to claim 10, wherein the non-volatile sacrificial material comprises a material having a higher redox potential than at least one other material in the pellicle membrane.

12. The pellicle membrane according to any of claims 10 or 11, wherein the non-volatile sacrificial material comprises one or more of elements selected from a list consisting of silver, gold, platinum, iron, manganese, and tellurium, and/or wherein the pellicle membrane is configured to have the non-volatile sacrificial material in direct contact with the hydrogen plasma environment of the lithographic apparatus.

## Patentansprüche

1. Ein optisches Element für einen lithographischen Apparat (LA), wobei das optische Element eine Pellikelanordnung (15) oder ein Spiegel (10, 11, 13, 14) ist und wobei das optische Element Folgendes beinhaltet:
- eine Oberschicht (20, 25), die in einem arbeitenden lithographischen Apparat oder einer plasmahaltigen Umgebung ein selbstterminierendes Wachstum aufweist, wobei die Oberschicht ein oder mehrere Elemente beinhaltet, die aus der Gruppe ausgewählt sind, die aus Si, Ge, Sn, B, P, Mg und Al besteht; und
- eine Ankerschicht (19, 24), die ausgewählt ist, um die Oberschicht zu tragen, wobei die Ankerschicht ein oder mehrere Elemente beinhaltet, die aus der Gruppe ausgewählt sind, die aus Pt, Ru, Os, Rh, Ir und Pd besteht; und
wobei die Ankerschicht und die Oberschicht eine Plasmaätzbarriere bilden.

2. Optisches Element gemäß Anspruch 1, wobei die Oberschicht ein Oxid eines oder mehrerer solcher Elemente beinhaltet.

3. Optisches Element gemäß einem der vorhergehenden Ansprüche, wobei das optische Element eine Ankerschicht-Oberschicht-Kombination umfasst, die aus der Liste ausgewählt ist, die aus Folgendem besteht: Ru-SiOx, Pt-SiOx, Rh-SiOx, Ru-GeOx, Rh-GeOx, Ru-SnOx und Rh-SnOx.

4. Optisches Element gemäß einem der vorhergehenden Ansprüche, wobei das optische Element ferner eine Benetzungsschicht (18, 23) beinhaltet.

5. Optisches Element gemäß Anspruch 4, wobei die Benetzungsschicht ein oder mehrere Elemente beinhaltet, die aus der Gruppe ausgewählt sind, die aus Cr, Ti und Mo besteht, wobei die Benetzungsschicht optional TiN beinhaltet.

6. Optisches Element gemäß einem der vorhergehenden Ansprüche, wobei das optische Element ferner eine Substratschicht (17, 22) beinhaltet.

7. Optisches Element gemäß Anspruch 6, wobei das Substrat Kohlenstoffnanoröhren beinhaltet.

8. Optisches Element gemäß Anspruch 7 in Kombination mit einem beliebigen der Ansprüche 4-5, das eine besagte Benetzungsschicht aus Molybdän, eine besagte Ankerschicht aus Ruthenium und eine besagte Oberschicht aus Siliciumoxid beinhaltet.

9. Ein Verfahren zum Herstellen eines optischen Elements gemäß einem der vorhergehenden Ansprüche, wobei das Verfahren die folgenden Schritte beinhaltet: Abscheiden der Oberschicht auf die Ankerschicht mittels Aussetzen gegenüber Plasma, vorzugsweise elektromagnetisch induziertem Plasma.

10. Eine Pellikelmembran (16) für einen lithographischen Apparat, wobei die Pellikelmembran ein nichtflüchtiges Opfermaterial umfasst, das andere Teile der Pellikelmembran vor Erosion schützt, wenn sie Wasserstoffplasma ausgesetzt wird, **dadurch gekennzeichnet, dass** das nichtflüchtige Opfermaterial in der Form diskreter Inseln und/oder Körnchen vorliegt.

11. Pellikelmembran gemäß Anspruch 10, wobei das nichtflüchtige Opfermaterial ein Material beinhaltet, das ein höheres Redoxpotential aufweist als mindestens ein anderes Material in der Pellikelmembran.

12. Pellikelmembran gemäß einem der Ansprüche 10 oder 11, wobei das nichtflüchtige Opfermaterial eines oder mehrere der Elemente beinhaltet, die aus einer Liste ausgewählt sind, die aus Silber, Gold, Platin, Eisen, Mangan und Tellur besteht, und/oder wobei die Pellikelmembran konfiguriert ist, um das nichtflüchtige Opfermaterial in direktem Kontakt mit der Wasserstoffplasmaumgebung des lithographischen Apparats aufzuweisen.

## Revendications

1. Un élément optique pour un appareil lithographique (LA), où l'élément optique est un ensemble à pellicule (15) ou un miroir (10, 11, 13, 14), et où l'élément optique comprend :
- une couche de dessus (20, 25) ayant une croissance à auto-terminaison dans un appareil lithographique en fonctionnement ou un environnement contenant un plasma, où la couche de dessus comprend un ou plusieurs éléments sélectionnés dans le groupe constitué de Si, Ge, Sn, B, P, Mg, et Al ; et
- une couche d'ancrage (19, 24) sélectionnée pour supporter la couche de dessus, où la couche d'ancrage comprend un ou plusieurs éléments sélectionnés dans le groupe constitué de Pt, Ru, Os, Rh, Ir, et Pd ; et
où la couche d'ancrage et la couche de dessus forment une barrière à la gravure par plasma.

2. L'élément optique selon la revendication 1, où la couche de dessus comprend un oxyde d'un ou de plusieurs de ces éléments.

3. L'élément optique selon n'importe quelle revendication précédente, où l'élément optique inclut une combinaison couche d'ancrage-couche de dessus sélectionnée dans la liste constituée de : Ru-SiOx, Pt-SiOx, Rh-SiOx, Ru-GeOx, Rh-GeOx, Ru-SnOx, et Rh-SnOx.

4. L'élément optique selon n'importe quelle revendication précédente, ledit élément optique comprenant en sus une couche de mouillage (18, 23).

5. L'élément optique selon la revendication 4, où la couche de mouillage comprend un ou plusieurs éléments sélectionnés dans le groupe constitué de Cr, Ti, et Mo, facultativement où la couche de mouillage comprend du TiN.

6. L'élément optique selon n'importe quelle revendication précédente, ledit élément optique comprenant en sus une couche de substrat (17, 22).

7. L'élément optique selon la revendication 6, où le substrat comprend des nanotubes de carbone.

8. L'élément optique selon la revendication 7 en combinaison avec n'importe lesquelles des revendications 4 à 5, comprenant une dite couche de mouillage en molybdène, une dite couche d'ancrage en ruthénium, et une dite couche de dessus en oxyde de silicium.

9. Un procédé de fabrication d'un élément optique selon n'importe quelle revendication précédente, ledit procédé comprenant les étapes : de dépôt de la couche de dessus sur la couche d'ancrage via une exposition à un plasma, préférablement un plasma induit électromagnétiquement.

10. Une membrane formant pellicule (16) pour un appareil lithographique, ladite membrane formant pellicule incluant un matériau sacrificiel non volatile protégeant d'autres parties de la membrane formant pellicule contre une érosion lorsqu'exposée à un plasma d'hydrogène, **caractérisée en ce que** le matériau sacrificiel non volatile se présente sous la forme d'îlots et/ou de grains discrets.

11. La membrane formant pellicule selon la revendication 10, où le matériau sacrificiel non volatile comprend un matériau qui a un potentiel redox plus élevé qu'au moins un autre matériau dans la membrane formant pellicule.

12. La membrane formant pellicule selon n'importe lesquelles des revendications 10 ou 11, où le matériau sacrificiel non volatile comprend un ou une pluralité d'éléments sélectionnés dans une liste constituée de l'argent, de l'or, du platine, du fer, du manganèse, et du tellure, et/ou bien où la membrane formant pellicule est configurée pour avoir le matériau sacrificiel non volatile au contact direct de l'environnement de plasma d'hydrogène de l'appareil lithographique.
